Europäisches Patentamt

European Patent Office

Office européen des brevets

(11) Veröffentlichungsnummer: **0 076 415**
**A1**

(12) **EUROPÄISCHE PATENTANMELDUNG**

(21) Anmeldenummer: 82108623.8

(22) Anmeldetag: 18.09.82

(51) Int. Cl.³: **H 03 G 7/00**

(30) Priorität: 03.10.81 DE 3139482

(43) Veröffentlichungstag der Anmeldung:
**13.04.83** Patentblatt **83/15**

(84) Benannte Vertragsstaaten:
**AT BE CH DE FR GB IT LI LU NL SE**

(71) Anmelder: **Licentia Patent-Verwaltungs-GmbH**
**Theodor-Stern-Kai 1**
**D-6000 Frankfurt/Main 70(DE)**

(72) Erfinder: **Zaunick, Günter**
**In der Rehre 29**
**D-3000 Hannover 91(DE)**

(74) Vertreter: **Einsel, Robert, Dipl.-Ing.**
**Theodor-Stern-Kai 1**
**D-6000 Frankfurt/Main 70(DE)**

(54) Expander für zur Störgeräuschverminderung komprimierte Audiosignale.

(57) Expander (E) für ein Kompandersystem mit je einem steuerbaren Verstärker (3,4) in den stereophonen Audiokanälen (1,2), bei dem aus beiden Kanälen eine gemeinsame signalabhängige Regelspannung (UR) abgeleitet und dem Verstärker zugeführt wird, wobei in den gemeinsamen Regelspannungsweg ein Umschalter (9) eingefügt ist, der von der Regelspannungsquelle (Anschluß 11) auf eine feste Gleichspannung (Anschluß 12) schaltbar ist, die z.B. dem Signalpegel O db entspricht.

Fig.1

EP 0 076 415 A1

Licentia Patent-Verwaltungs-GmbH
Theodor-Stern-Kai 1

6000 Frankfurt/Main 70


Hannover, den 01.10.1981
Z13 PTL-Es/ds


## Expander für zur Störgeräuschverminderung komprimierte Audiosignale

Es sind Kompander bekannt, bei denen Audiosignale vor ihrer Aufzeichnung auf einem Speichermedium komprimiert und nach ihrer Abtastung von diesem Medium wieder expandiert werden. Solche Kompander haben den Vorteil, daß die wiedergegebenen Audiosignale nur noch geringe Rausch- und Störanteile haben. Zu dem bisher nur schwer lösbaren Problem solcher Kompander gehört die kompatible Wiedergabe komprimierter Audiosignale mit Geräten ohne Expander. Ein Kompander mit relativ hoher Kompression und relativ guter Kompatibilität ist unter dem Namen CX bekannt geworden (Internationale Funkausstellung Berlin, 1981). Bei diesem bekannten Kompander werden die stereophonen Audiosignale komprimiert, indem sie über je einen von einer Regelspannung gesteuerten Verstärker geleitet werden, wobei die Regelspannung aus Signalanteilen mit mehr als 500 Hz gewonnen wird, die einem Spitzengleichrichter mit vorbestimmter Zeitkonstante zugeführt

- 3 -
2

werden. Derart komprimierte Audiosignale können kompatibel wiedergegeben werden, weil durch die Regelung keine Frequenzgangänderung bewirkt wird, weil höchstwertiges störgeräuscharmes Ursprungssignal komprimiert aufgezeichnet wird, weil Schallplattenmaterial mit geringem Rauschanteil verwendet wird und weil die Kompression weniger als 20 db beträgt.

Der bekannte Expander ist mit mehreren Schaltern versehen, die bei Expanderbetrieb oder Nichtexpanderbetrieb betätigt werden müssen, um den Expander einzusetzen oder zu überbrücken. Der Erfindung liegt die Aufgabe zugrunde, die Umschaltung des Expanders zu vereinfachen. Diese Aufgabe wird bei einem Expander.nach dem Oberbegriff des Anspruchs 1 durch die im Kennzeichen aufgeführten Merkmale gelöst.

Zur näheren Erläuterung der Erfindung wird im folgenden ein Ausführungsbeispiel an Hand der Zeichnung beschrieben. Diese zeigt in
Fig. 1 ein Blockschaltbild und in
Fig. 2 ein Detailschaltbild eines Expanders gemäß der Erfindung.

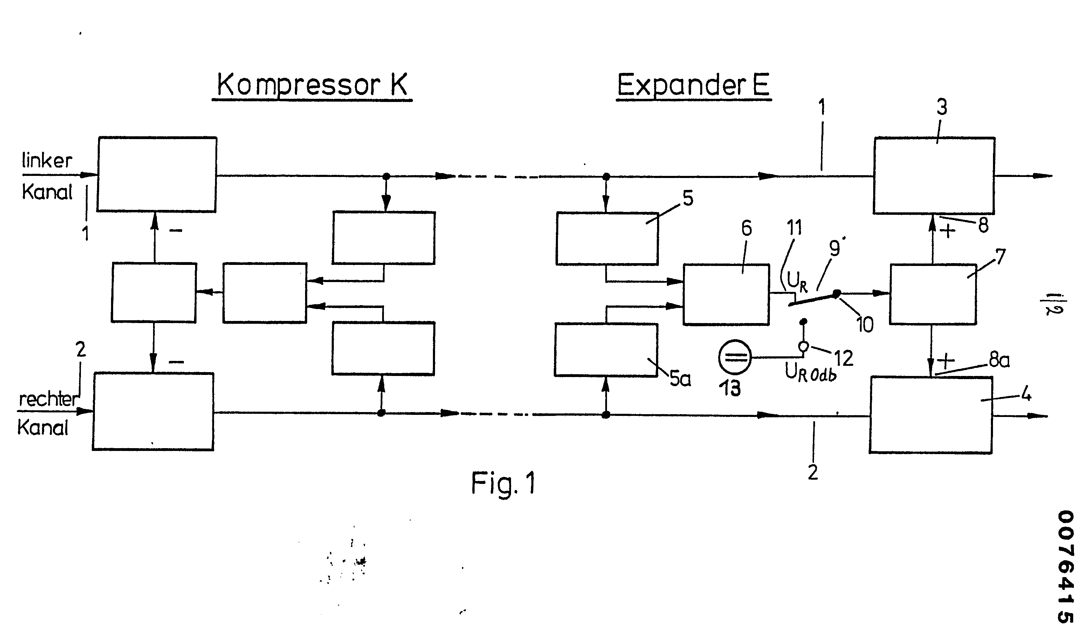

In Fig. 1 ist ein Kompander mit einem Kompressor K und einem Expander E dargestellt, die im wesentlichen spiegelbildlich aufgebaut sind. Kompressor und Expander können bei Verwendung für Recorder durch ein Bauteil realisiert sein. Bei Verwendung für Schallplatten wird jedoch der Kompressor durch die Schallplattenindustrie vor der Pressung der Schallplatten benutzt, während der Expander bei Geräten eingesetzt wird, mit denen Schallplatten abgespielt werden. Der Expander E ist für jeden Kanal 1,2 mit einem steuerbaren Verstärker 3,4 versehen. An jeden Kanal 1,2 ist ein Hochpaßfilter 5,5a angeschlossen, deren Ausgänge mit einem gemeinsamen Gleichrichter 6 zur Gewinnung einer signalabhängigen Regelgleichspannung verbunden sind. Diese Regelgleichspannung wird den Steuereingängen der beiden Verstärker 3,4 zugeführt. Durch die symmetrische Regelung wird
erreicht, daß der Expander keine Beeinflussung des Stereoeffektes mit sich bringt. Ein Filter schneller Zeitkonstante
und ein Filter 7 längerer Zeitkonstante tragen zum optimalen Kompanderverhalten bei. Zur Umschaltung von Expanderwirkung auf Nichtexpanderwirkung ist ein Umschalter 9 vorgesehen, der einen Ausgangsanschluß 10, einen Anschluß 11
für den Gleichrichter 6 und einen weiteren Anschluß 12
für eine feste Gleichspannung vorbestimmter Größe aufweist.
Dieser Umschalter ist unempfindlich gegen Übersprechen und
gegen Fremdspannungen, weil keine Signale über diesen
Umschalter geführt werden. Die Gleichspannung ist so bemessen, daß sie der Regelspannung entspricht, die bei einem
Signal von 0 db, also bei Vollaussteuerung gewonnen wird.
Dadurch wird die Regelspannung unwirksam bei einer Verstärkung, die bei dem 0 db-Pegel vorhanden wäre. Das bedeutet, daß in diesem Fall bei einer Umschaltung die Lautstärke praktisch unverändert bleibt. Es können aber auch
andere Spannungen eingesetzt werden, wenn andere Effekte
erreicht werden sollen. Mit einer einstellbaren Spannung
kann jeweils die erwünschte Verstärkung eingestellt
werden. Wesentlich ist jedoch, daß die Expanderwirkung
z.B. beim Abspielen nichtkomprimierter (normaler) Schallplatten abschaltbar ist. Selbstverständlich kann auch die
Wahl der Vorspannung eine evtl. gewünschte andere Verstärkung eingestellt werden.

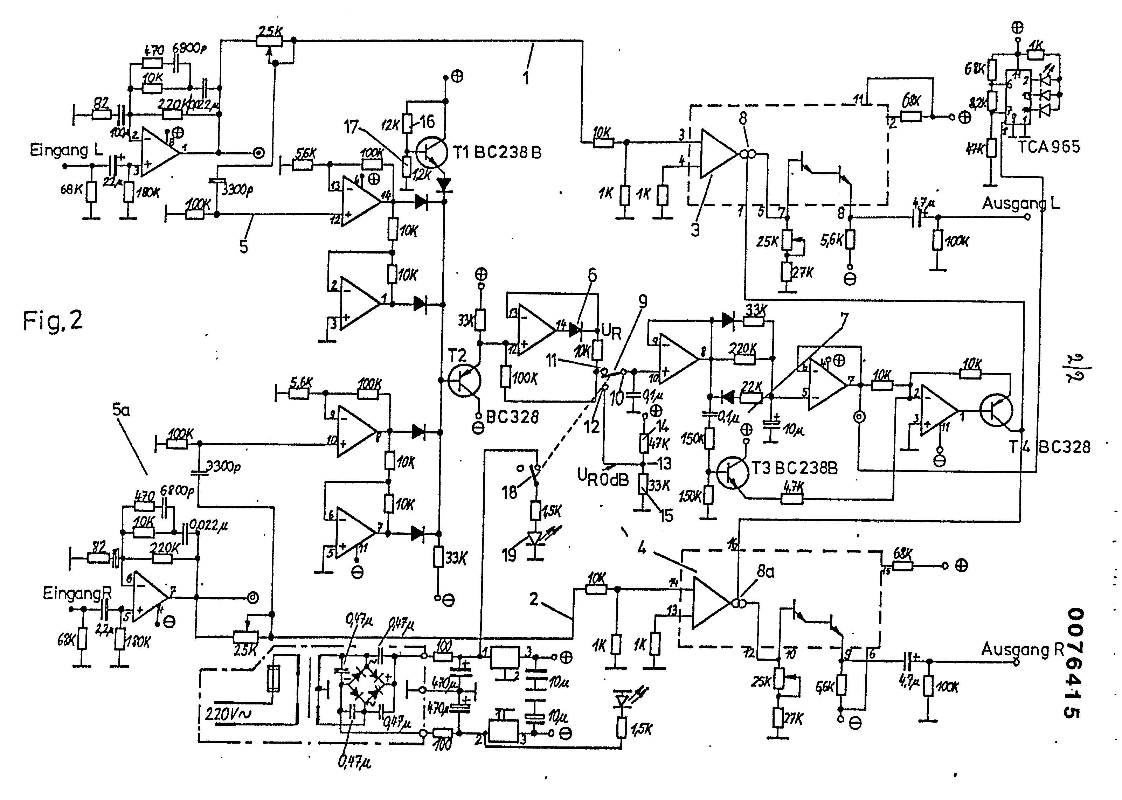

In Fig. 2 ist die vollständige Schaltung eines CX-Kompanders dargestellt. Der Umschalter 9 ist direkt hinter den Ausgang des Gleichrichters 6 eingefügt. Er ist mit einem weiteren Schalter 18 gekuppelt, der die Anzeigeleuchte 19 in Betrieb setzt. Wenn auch die dargestellte Anordnung des Umschalters 9 optimal ist, so können die angestrebten Vorteile auch angenähert werden, wenn der Umschalter 9 in modifizierter Form ab Basis des Transistors T2 in allen Stufen bis zur Basis des Transistors T4 eingefügt wird. Ähnliches kann auch durch Anordnung eines Schalters vor dem Gleichrichter 6 erreicht werden, z.B. durch Umschalten des Basisspannungsteilers 16,17 des Transistors T1. Dann wird die Expanderwirkung bei Pegeln unterhalb eines Schwellwertes (z.B. bei 0 db) unwirksam, oberhalb des Schwellwertes bleibt sie jedoch wirksam.

P a t e n t a n s p r ü c h e

1. Expander für zur Störgeräuschverminderung komprimierte mehrkanalige Audiosignale, die auf einem Aufzeichnungsträger, insbesondere einer Schallplatte aufgezeichnet sind, dadurch gekennzeichnet, daß

   a) für jeden Kanal (1,2) ein steuerbarer Verstärker (3,4) vorgesehen ist

   b) jedem Kanal vor dem Verstärker (3,4) je ein Hochpaßfilter (5,5a) zugeordnet ist und daß die Ausgänge der Hochpaßfilter (5,5a) mit dem Eingang einer Gleichrichterschaltung (6) verbunden sind, die zur Gewinnung einer von der Signalamplitude abhängigen Regelspannung ausgelegt ist

   c) dem Ausgang der Gleichrichterschaltung (6) ein Zeitkonstantenglied (7) zugeordnet ist, das mit den Steuereingängen (8,8a) der Verstärker (3,4) verbunden ist

   d) zur Umschaltung von Expanderwirkung auf Nichtexpanderwirkung der beiden Kanälen gemeinsame Weg des Expanders auf einen Spannungswert schaltbar ist, der einem vorbestimmten Signalwert, insbesondere Vollaussteuerung entspricht.

2. Expander nach Anspruch 1, dadurch gekennzeichnet, daß hinter dem Gleichrichter (6) ein Umschalter (9) vorgesehen ist, der einen Ausgang (10) für den Regelspannungsweg, einen Anschluß (11) für den Gleichrichter (6) und einen weiteren Anschluß (12) aufweist, der an eine Spannungsquelle (13) angeschlossen ist.

3. Expander nach Anspruch 1, <u>dadurch gekennzeichnet</u>, daß
   die Spannungsquelle (13) so bemessen ist, daß die Spannung
   am Anschluß (12) so groß ist  wie die Ausgangsspannung
   des Spitzengleichrichters bei einem Pegel O db, d.h.
   Vollaussteuerung.

4. Expander nach Anspruch 1, <u>dadurch gekennzeichnet</u>, daß
   die Spannungsquelle (13) so bemessen ist, daß die am
   weiteren Anschluß (12) wirksame Spannung kleiner oder
   größer ist als die bei Vollaussteuerung am Anschluß (11)
   wirksame Spannung.

5. Expander nach einem der Ansprüche 1 - 4, <u>dadurch gekenn-
   zeichnet</u>, daß die Spannung für den weiteren Anschluß·
   einstellbar ist.

6. Expander nach einem der Ansprüche 1 - 3, <u>dadurch gekenn-
   zeichnet</u>, daß die Spannungsquelle einen Spannungsteiler
   zwischen zwei festen Betriebsspannungen enthält.

7. Expander nach einem der Ansprüche 1 - 6, <u>dadurch gekenn-
   zeichnet</u>, daß der Basisspannungsteiler (16,17) eines vor
   dem Gleichrichter (6) angeordneten Verstärkers (T1)
   umschaltbar ist.

0076415

Expander E

Kompressor K

Fig. 1

linker Kanal

rechter Kanal

Fig.2

2/2

0076415

# EUROPÄISCHER RECHERCHENBERICHT

EP 82 10 8623

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl. ³) |
|---|---|---|---|
| | --- | | H 03 G 7/00 |
| Y | US-A-4 162 457 (GRODINSKY) * Figuren 1-3; Spalte 4, Zeile 23 - Spalte 7, Zeile 62 * | 1 | |
| | --- | | |
| Y | DE-A-2 924 373 (LICENTIA) * Figur 3; Seite 5, Zeile 1 - Seite 6, Zeile 7 * | 1,2,4 | |
| | --- | | |
| A | WIRELESS WORLD, Band 84, Nr. 1511, Juli 1978, Seite 74, London, G.B. L. MAYES: "Audio compressor" * Insgesamt * | 1,5,6 | |
| | --- | | |
| A | DE-A-1 914 071 (BLAUPUNKT-WERKE) * Figur; Seiten 3,4 * | 1 | RECHERCHIERTE SACHGEBIETE (Int. Cl. ³) |
| | --- | | |
| A | DE-A-1 915 511 (GRAETZ) * Figur 2; Seite 4, Zeile 24 - Seite 6 * | 1-3 | H 03 G<br>H 04 S<br>H 04 R |
| | --- | | |
| P,A | EP-A-0 041 310 (CBS) * Figur 2; Seite 14, Zeile 24 - Seite 18, Zeile 25 * | 1 | |
| | ----- | | |

Der vorliegende Recherchenbericht wurde für alle Patentansprüche erstellt.

| Recherchenort DEN HAAG | Abschlußdatum der Recherche 07-01-1983 | Prüfer GYSEN L.A.D. |
|---|---|---|